# EUROPEAN PATENT APPLICATION

(11) **EP 4 790 893 A1**
(43) Date of publication of application: **12.08.2026**
(21) Application number: 24879900.9
(22) Date of filing: 01.08.2024
(51) Int. Cl.: H03F 1/02, H03F 3/193, H03F 1/56, H03F 3/21, H03F 3/60

(54) **DOHERTY POWER AMPLIFIER AND ELECTRONIC DEVICE COMPRISING SAME**

(30) Priority: 18.10.2023 KR 20230139955; 29.11.2023 KR 20230170196
(71) Applicant: Samsung Electronics Co., Ltd., Suwon-si, Gyeonggi-do 16677 (KR)
(72) Inventor: LEE, Jooseok, Suwon-si Gyeonggi-do 16677 (KR); OH, Hansik, Suwon-si Gyeonggi-do 16677 (KR); YANG, Sunggi, Suwon-si Gyeonggi-do 16677 (KR); PARK, Seungwon, Suwon-si Gyeonggi-do 16677 (KR)
(74) Representative: Gulde & Partner
(86) International application number: PCT/KR2024/011354
(87) International publication number: WO 2025/084560

(57) **Abstract**

In various embodiments, a circuit is provided. The circuit may include a driver amplification circuit, a phase offset circuit, a balun circuit, a carrier amplifier circuit, and a peaking amplifier circuit. The phase offset circuit may include a first line coupled to the driver amplification circuit and configured to provide a first single-end signal having a first phase delay. The phase offset circuit may include a second line coupled to the driver amplification circuit and configured to provide a second single-end signal having a second phase delay different from the first phase delay of the first single-end signal provided by the first line. The balun circuit may include a first balun circuit connected between the first line and the carrier amplifier circuit and a second balun circuit connected between the second line and the peaking amplifier circuit.

## Description

### [Technical Field]

The disclosure relates to a doherty power amplifier and an electronic device comprising the doherty power amplifier.

### [Background Art]

Products equipped with multiple antennas are being developed to increase communication performance. As the number of antennas increases, the number of RF components (e.g., power amplifiers (PA)) for processing signals received through or radiated through the antennas also increases.

The above information is presented as background information simply to assist with an understanding of the disclosure. No determination has been made, and no assertion is made, as to whether any of the above might be applicable as prior art with regard to the disclosure.

### [Disclosure]

### [Technical Solution]

In various example embodiments, circuitry is provided. The circuitry may comprise driver amplification circuitry, phase offset circuitry, balun circuitry, carrier amplifier circuitry, and peaking amplifier circuitry. The phase offset circuitry may comprise a first line connected to the driver amplification circuitry and configured to provide a first single-ended signal having a first phase delay. The phase offset circuitry may comprise a second line connected to the driver amplification circuitry and configured to provide a second single-ended signal having a second phase delay different from the first phase delay of the first single-ended signal of the first line. The balun circuitry may comprise first balun circuitry connected between the first line and the carrier amplifier circuitry, and second balun circuitry connected between the second line and the peaking amplifier circuitry.

In various example embodiments, an electronic component is provided. The electronic component may comprise a power divider comprising circuitry and a plurality of radio frequency (RF) paths, and each of the plurality of RF paths may comprise: a phase shifter and a power amplifier. The power amplifier may comprise: driver amplification circuitry, phase offset circuitry, balun circuitry, carrier amplifier circuitry, and peaking amplifier circuitry. The phase offset circuitry may comprise a first line and a second line that connect the driver amplification circuitry and the balun circuitry. The balun circuitry may comprise a first transformer for the carrier amplifier circuitry and a second transformer for the peaking amplifier circuitry. The first line may be configured to provide a first single-ended signal to the first transformer. The second line may be configured to provide a second single-ended signal to the second transformer.

In various example embodiments, an electronic device is provided. The electronic device may comprise: a plurality of antennas, radio frequency integrated circuitry (RFIC) for the plurality of antennas, and at least one processor comprising processing circuitry. The RFIC may comprise a power divider comprising circuitry and a plurality of RF paths. Each of the plurality of RF paths may comprise a phase shifter and a power amplifier. The power amplifier may comprise: driver amplification circuitry, phase offset circuitry, balun circuitry, carrier amplifier circuitry, and peaking amplifier circuitry. The phase offset circuitry may comprise lines connecting the driver amplification circuitry and the balun circuitry. The balun circuitry may comprise a first transformer for the carrier amplifier circuitry and a second transformer for the peaking amplifier circuitry. A first line of the lines may be configured to provide a first single-ended signal to the first transformer. A second line of the lines may be configured to provide a second single-ended signal to the second transformer.

In various example embodiments, a differential two-stage Doherty PA is provided. The differential two-stage Doherty PA may comprise: driver amplification circuitry, phase offset circuitry, balun circuitry, and Doherty amplification circuitry including carrier amplifier circuitry and peaking amplifier circuitry. The phase offset circuitry may be connected to a first line connected to the driver amplification circuitry in a single-ended scheme and the driver amplification circuitry in a single-ended scheme. A second line providing a second phase delay different from a first phase delay of the first line may be included. The balun circuitry may include first balun circuitry connected to the first line and the carrier amplifier circuitry and second balun circuitry connected to the second line and the peaking amplifier circuitry.

In various example embodiments, an electronic component is provided. The electronic component may comprise: a power divider comprising circuitry, and a plurality of radio frequency (RF) paths. Each of the plurality of RF paths may comprise: a phase shifter and a power amplifier. The power amplifier may comprise: driver amplification circuitry, phase offset circuitry, balun circuitry, and Doherty amplification circuitry including carrier amplifier circuitry and peaking amplifier circuitry. The phase offset circuitry may comprise a first line and a second line that connect the driver amplification circuitry and the balun circuitry in a single-ended scheme. The balun circuitry may comprise a first transformer for the carrier amplifier circuitry and a second transformer for the peaking amplifier circuitry.

In various example embodiments, an electronic device is provided. The electronic device may comprise: a plurality of antennas, radio frequency integrated circuitry (RFIC) for the plurality of antennas, and at least one processor comprising processing circuitry. The RFIC may comprise: a power divider comprising circuitry and a plurality of RF paths. Each of the plurality of RF paths may comprise a phase shifter and a power amplifier. The power amplifier may comprise: driver amplification circuitry, phase offset circuitry, balun circuitry, and Doherty amplification circuitry including carrier amplifier circuitry and peaking amplifier circuitry. The phase offset circuitry may comprise lines connecting the driver amplification circuitry and the balun circuitry in a single-ended scheme. The balun circuitry may comprise a first transformer for the carrier amplifier circuitry and a second transformer for the peaking amplifier circuitry.

### BRIEF DESCRIPTION OF THE DRAWINGS

The above and other aspects, features and advantages of certain embodiments of the present disclosure will be more apparent from the following detailed description, taken in conjunction with the accompanying drawings, in which:
FIG. 1 illustrates a wireless communication system.
FIG. 2A illustrates an example of network entities of an electronic device.
FIG. 2B illustrates an example of an electronic device including a Doherty power amplifier (PA).
FIG. 2C illustrates another example of an electronic device including a Doherty PA.
FIG. 2D illustrates still another example of an electronic device including a Doherty PA.
FIG. 3 illustrates an example of components of a two-stage Doherty PA.
FIG. 4A illustrates an example of a two-stage Doherty PA including phase offset circuitry in a single-ended scheme.
FIG. 4B illustrates a phase for each point of a two-stage Doherty PA.
FIG. 5 illustrates an example of a two-stage Doherty PA including phase off circuitry in a single-ended scheme.
FIG. 6 illustrates an example of performance of a two-stage Doherty PA including phase off set circuitry in a single-ended scheme.
FIG. 7 illustrates an example of components of an electronic device.

### DETAILED DESCRIPTION

The terms used in the disclosure are merely used to better describe various example embodiments and are not be intended to limit the scope of the disclosure or any embodiments described herein. A singular expression may include a plural expression, unless the context clearly dictates otherwise. The terms used herein, including technical and scientific terms, may have the same meanings as those commonly understood by those skilled in the art to which the disclosure pertains. Terms defined in a general dictionary amongst the terms used in the disclosure may be interpreted as having the same or similar meaning as those in context of the related art, and they are not to be construed in an ideal or overly formal sense, unless explicitly defined in the disclosure. In some cases, even the terms defined in the disclosure may not be interpreted to exclude embodiments of the disclosure.

In various examples of the disclosure described below, a hardware approach will be described as an example. However, since various embodiments of the disclosure may include the technology that utilizes both the hardware-based approach and the software-based approach, they are not intended to exclude the software-based approach.

As used in the following description, terms referring to signals (e.g., signal, information, message, signaling), and terms referring to network entities (e.g., electronic device, unit, RU, DU, CU, module, communication module, RF unit, RF module, RF circuit), terms referring to component of electronic device (e.g., substrate, print circuit board (PCB), flexible PCB (FPCB), module, antenna, antenna element, circuit, processor, chip, component, device), terms referring to circuitry (e.g. PCB, FPCB, signal line, feeding line, data line, RF signal line, antenna line, RF path, RF module, RF circuit, splitter, divider, coupler, combiner, electronic component, electronic part, electronic products, etc.) are illustrated for convenience of description in the disclosure. Therefore, the disclosure is not limited to those terms described below, and other terms having the same or equivalent technical meaning may be used therefor. Further, as used herein, the terms such as '~ module', '~ unit', '~ section', '~ part', '~ body', or the like may refer to at least one shape of structure or a unit for processing a certain function.

Further, throughout the disclosure, an expression such as e.g., 'above' or 'below' may be used to determine whether a specific condition is satisfied or fulfilled, but it is merely of a description for expressing an example and is not intended to exclude the meaning of 'more than or equal to' or 'less than or equal to'. A condition described as 'more than or equal to' may be replaced with an expression such as 'above', a condition described as 'less than or equal to' may be replaced with an expression such as 'below', and a condition described as 'more than or equal to and below' may be replaced with 'above and less than or equal to', respectively. Furthermore, hereinafter, 'A' to 'B' may refer, for example, to at least one of the elements from A (including A) to B (including B). Hereinafter, 'C' and/or 'D' may refer, for example, to including at least one of 'C' or 'D', that is, {'C', 'D', or 'C' and 'D'}.

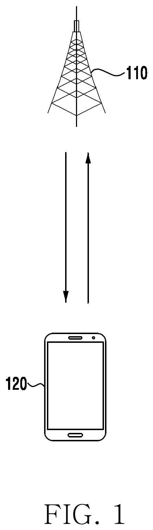

FIG. 1 illustrates a wireless communication system.

Referring to FIG. 1, it illustrates a base station 110 and a terminal 120 as a part of nodes using a wireless channel in a wireless communication system. Although FIG. 1 illustrates only one base station, the wireless communication system may further include another base station that is the same as or similar to the base station 110.

The base station 110 is a network infrastructure that provides wireless access to the terminal 120. The base station 110 may have a coverage defined based on a range capable of transmitting a signal. In addition to the term 'base station', the base station 110 may be referred to as 'access point (AP), 'eNodeB (eNB)', '5th generation node', 'next generation nodeB (gNB)', 'wireless point', 'transmission/reception point (TRP)', or any other terms having the same or equivalent meaning thereto.

The terminal 120, is a device used by a user, and performs communications with the base station 110 via a wireless channel. A link from the base station 110 to the terminal 120 is referred to as a downlink (DL), and a link from the terminal 120 to the base station 110 is referred to as an uplink (UL). Further, although not shown in FIG. 1, the terminal 120 and other terminals may perform communications with each other through the wireless channel. In this context, a link between the terminal 120 and another terminals (device-to-device link, D2D) is referred to as a side link, and the side link may be used mixed with a PC5 interface. In some other embodiments, the terminal 120 may be operated without any involvement by a user. According to an embodiment, the terminal 120, which is a device that performs machine-type communication (MTC), may not be carried by a user. Further, according to an embodiment, the terminal 120 may be a narrowband (NB)-Internet of things (IoT) device. The terminal 120 may be referred to as 'user equipment (UE), 'customer premises equipment (CPE)', 'mobile station', 'subscriber station', 'remote terminal', 'wireless terminal', 'electronic device', 'user device', or any other term having the same or equivalent technical meaning thereto.

The base station 110 may perform beamforming with the terminal 120. The base station 110 and the terminal 120 may transmit and receive radio signals in a relatively low frequency band (e.g., FR 1 (frequency range 1) of NR). Further, the base station 110 and the terminal 120 may transmit and receive radio signals in a relatively high frequency band (e.g., FR 2 of NR (or FR 2-1, FR 2-2, FR 2-3), FR 3 of NR, or a millimeter wave (mmWave) band (e.g., 28 GHz, 30 GHz, 38 GHz, 60 GHz)). In order to enhance the channel gain, the base station 110 and the terminal 120 may perform beamforming. In this context, the beamforming may include transmission beamforming and reception beamforming. The base station 110 and the terminal 120 may assign directivity to a transmission signal or a reception signal. To this end, the base station 110 and the terminal 120 may select serving beams by means of a beam search or beam management procedure. After the serving beams are selected, subsequent communication may be performed through a resource having a QCL relationship with a resource that has transmitted the serving beams.

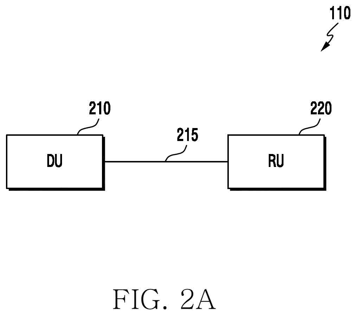

In the past, in a communication system with a relatively large cell radius of the base station, each base station was installed so that each base station includes functions of a digital processing unit (or digital unit (DU)) and a radio frequency (RF) processing unit (or radio unit (RU)). However, as a high frequency band is used in 4th generation (4G) and/or subsequent communication systems (e.g., 5G), and a cell coverage of the base station decreases, the number of base stations to cover a specific area has increased. The burden of installation cost for operators to install base stations has also increased. In order to minimize and/or reduce the installation cost of the base station, the base station is divided into two or more network nodes. A structure has been disclosed in which one or more other network nodes (e.g., lower network nodes) are connected to one network node (e.g., upper network node) through a wired network, and one or more lower network nodes are distributed geographically to cover a specific area. Hereinafter, an arrangement structure and an extended example of the base station according to various embodiments of the present disclosure will be described in greater detail below with reference to FIG. 2A.

FIG. 2A illustrates an example of network entities of an electronic device. For example, the electronic device may include the base station 110 of FIG. 1. The base station 110 may be divided into two or more entities. The base station 110 may include an upper network node and a lower network node. For example, the base station 110 may be divided into two or more entities through a fronthaul. The fronthaul refers to an interface between an upper network node (e.g., DU) and a lower network node (e.g., RU) between a wireless network and a core network. FIG. 2A illustrates an example of a fronthaul structure between one DU and one RU, but it is only for convenience of description and the present disclosure is not limited thereto. In other words, an embodiment of the present disclosure may be applied to a fronthaul structure between one DU and a plurality of RUs. For example, an embodiment of the present disclosure may be applied to a fronthaul structure between one DU and two RUs. In addition, an embodiment of the present disclosure may be applied to a fronthaul structure between one DU and three RUs.

Referring to FIG. 2A, the base station 110 may include an upper network node 210 and a lower network node 220. A fronthaul 215 between the upper network node 210 and the lower network node 220 may be operated through a Fₓ interface. For operation of fronthaul 215, for example, an interface such as a common public radio interface (CPRI), an enhanced common public radio interface (eCPRI), and a radio over ethernet (ROE) may be used.

With development of communication technology, mobile data traffic has increased, and accordingly, bandwidth requirements required by a fronthaul between a digital unit and a wireless unit have increased significantly. In deployments such as a centralized/cloud radio access network (C-RAN), the upper network node 210 may be implemented to perform functions for a packet data convergence protocol (PDCP), a radio link control (RLC), a media access control (MAC), and physical (PHY), and the lower network node 220 may be implemented to further perform functions for a PHY layer in addition to a radio frequency (RF) function. As a non-limiting example, the upper network node 210 may be divided into a central unit (CU) (or a control unit (CU)) and a distributed unit (DU).

The upper network node 210 may serve as an upper layer function of a wireless network. For example, the upper network node 210 may perform a function of a MAC layer and a portion of the PHY layer. Herein, the portion of the PHY layer is performed at a higher level among functions of the PHY layer, and may include, for example, a channel encoding (or channel decoding), a scrambling (or descrambling), a modulation (or demodulation), a layer mapping (or layer de-mapping). According to an embodiment, in case that the upper network node 210 complies with O-RAN standard, it may be referred to as an O-RAN DU (O-DU). In embodiments of the present disclosure, the upper network node 210 may be represented by being replaced with a first network entity for a base station (e.g., gNB), as needed.

The lower network node 220 may serve a lower layer function of a wireless network. For example, the lower network node 220 may perform a portion of the PHY layer and an RF function. The portion of the PHY layer is performed at a relatively lower stage than the upper network node 210 among the functions of the PHY layer, and may include, for example, a iFFT conversion (or FFT conversion), a CP insertion (or CP removal), and a digital beamforming. The lower network node 220 may be referred to as an access unit (AU), an access point (AP), a transmission/reception point (TRP), a remote radio head (RRH), a radio unit (RU) or another term having a technical meaning equivalent thereto. According to an embodiment, in case that the lower network node 220 complies with the O-RAN standard, it may be referred to as an O-RAN RU (O-RU). In embodiments of the present disclosure, the lower network node 220 may be represented by being replaced with a second network entity for a base station (e.g., gNB), as needed. According to an embodiment, circuitry including a Doherty PA may be included in the lower network node 220 of the base station 110 having a distributed arrangement.

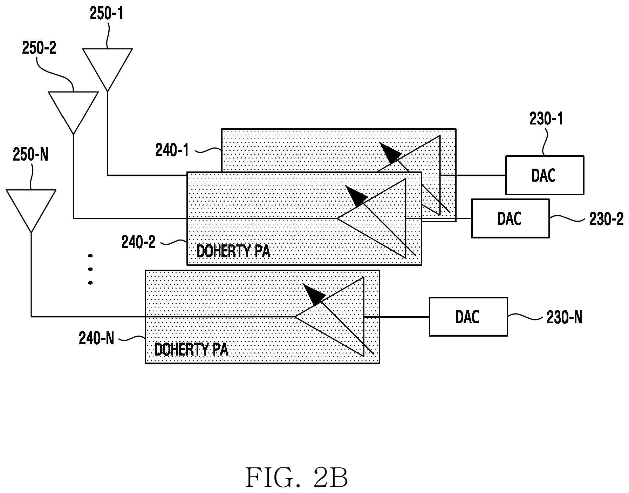

FIG. 2B illustrates an example of an electronic device (e.g., base station 110, terminal 120, and lower network node 220) including a Doherty power amplifier (PA). An example of an electronic device including a power amplifier (PA) is illustrated. For example, the electronic device may be the base station 110. For example, the device may be the lower network node 220.

Referring to FIG. 2B, the electronic device may include a plurality of antennas 250-1, 250-2, ..., and 250-N (where N is an integer greater than or equal to two). The electronic device may include RF processing circuitry to transmit a wireless signal. In order for signals to be radiated through a plurality of antennas, the RF processing circuitry may include a plurality of RF paths. The electronic device may include an up converter that up-converts a digital transmission signal in a baseband into a transmission frequency, and a digital-to-analog converter (DAC) that converts the up-converted digital transmission signal into an analog RF transmission signal. For example, the electronic device may include a DAC for each RF paths. The electronic device may include DACs 230-1, 230-2, ..., and 230-N.

In a wireless communication system, since a transmission signal of a base station or a terminal is transmitted through a wireless channel, the transmission signal is severely attenuated. Accordingly, the electronic device may be configured to include an amplifier for amplifying the transmission signal. In order to amplify a signal transmitted through the air, a PA may be disposed in a RF path. According to embodiments of the present disclosure, the electronic device may include a Doherty PA. For example, the Doherty PA may be disposed in each RF path. The electronic device may include a plurality of Doherty PAs 240-1, 240-2, ..., and 240-N. An analog RF signal output through a DAC 230-i may be amplified through a Doherty PA 240-i. The Doherty PA 240-i may amplify an applied signal and transmit the amplified signal to an antenna 250-i.

Beamforming technology is being used as one of technologies to mitigate radio wave path loss and increase a transmission distance of radio wave. In general, beamforming concentrates a reach area of radio wave using a plurality of antennas, or increases directivity of reception sensitivity in a specific direction. Accordingly, in order to form a beamforming coverage instead of forming a signal in an isotropic pattern using a single antenna, the electronic device may include a plurality of antennas. According to an embodiment, the electronic device may include a massive MIMO unit (MMU). A form in which the plurality of antennas are collected may be referred to as an antenna array, and each antenna included in the array may be referred to as an array element or an antenna element. The antenna array may be configured in various forms such as a linear array and a planar array. The antenna array may be referred to as a massive antenna array.

For higher data capacity, the number of RF paths should be increased or the power for the RF path should be increased. Increasing the RF path increases size of the product, and there is a spatial limitation in installing actual base station equipment. In order to increase antenna gain through high output without increasing the number of RF paths, a plurality of antenna elements may be connected to one RF path using a divider (or splitter) in the RF path. As a signal is radiated through the plurality of antenna elements, the antenna gain may increase. Antenna elements corresponding to the RF path may be referred to as a sub-array.

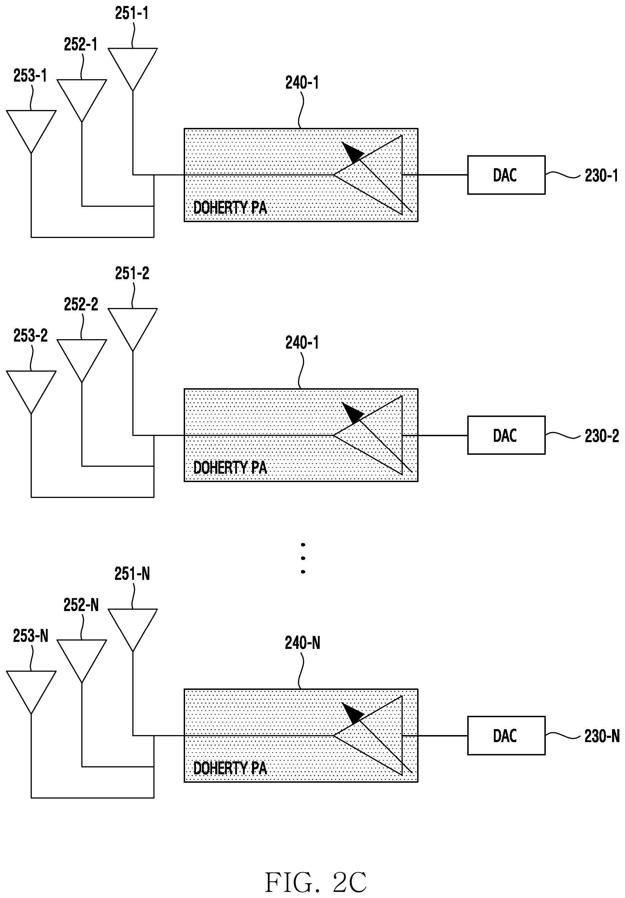

FIG. 2C illustrates another example of an electronic device (e.g., base station 110, terminal 120, and lower network node 220) including the Doherty PA. For example, the electronic device may be the base station 110. For example, the device may be the lower network node 220. The electronic device may transmit and/or receive a signal using the above-described sub-array. In FIG. 2C, a 3x1 sub-array is described as an example.

Referring to FIG. 2C, an electronic device may include a plurality of antennas. The plurality of antennas may be distributed by a sub-array unit. The sub-array may include a plurality of antenna elements. For example, a first sub-array of the electronic device may include antenna elements 251-1, 252-1, and 253-1. A second sub-array of the electronic device may include antenna elements 251-2, 252-2, and 253-2. In this way, the Nth sub-array of the electronic device may include antenna elements 251-N, 252-N, and 253-N. The electronic device may include RF processing circuitry to transmit a wireless signal. In order for signals to be radiated through a plurality of antennas, the RF processing circuitry may include a plurality of RF paths. For example, the electronic device may include DACs for each RF path. The electronic device may include DACs 230-1 and 230-2, ..., and 230-N.

Each RF path may be connected to a sub-array. Sub-array technology indicates technology supplying power to a power-supplied signal by dividing into several antenna elements for increasing gain of the corresponding signal. The electronic device may include a Doherty PA. For example, the Doherty PA may be disposed in each RF path. The electronic device may include a plurality of Doherty PAs 240-1, 240-2, ..., and 240-N. An analog RF signal output through a DAC 230-i may be amplified through a Doherty PA 240-i. The Doherty PA 240-i may amplify the applied signal and transmit the amplified signal to antenna elements 251-i, 252-i, and 253-i of the sub-array of the corresponding RF path.

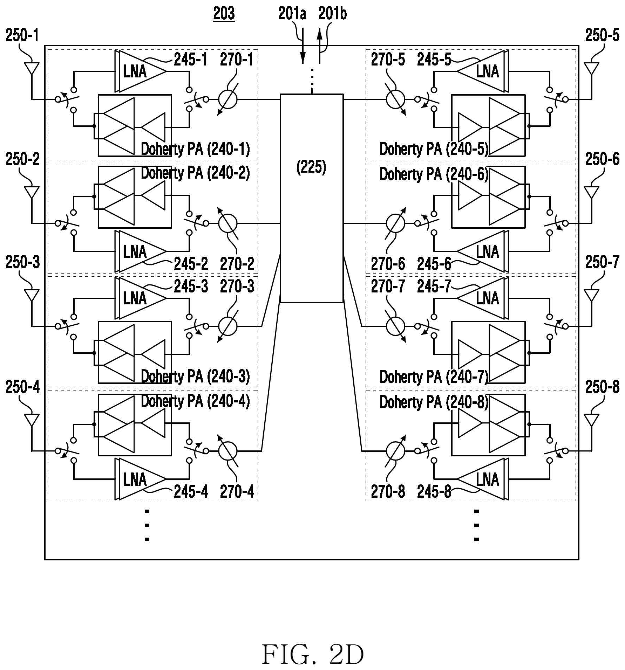

FIG. 2D illustrates still another example of an electronic device including a Doherty PA. For example, the electronic device may be the base station 110. For example, the device may be the lower network node 220. In FIG. 2D, an example in which the Doherty PA is disposed in a chip type component (e.g., RFIC, beamforming RFIC, mmWave RFIC) is described.

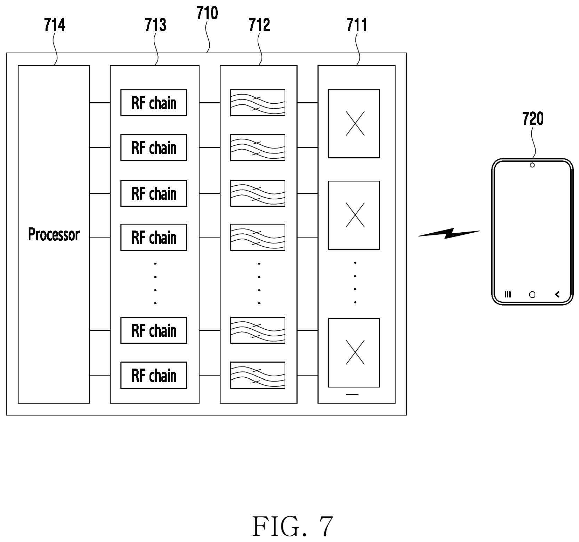

Referring to FIG. 2D, a component 203 may include a power divider 225. For example, a RF signal 201a input to the component 203 may be transmitted to a plurality of RF paths (e.g., transmission paths) through the power divider 225. The signals transmitted through the plurality of RF paths may be radiated to the outside through antennas. For another example, signals received through antennas may be transmitted to a processor (e.g., a processor 714 of FIG. 7) as an RF signal 201b, through the plurality of RF paths (e.g., reception paths) and the power divider 225.

The component 203 may include a plurality of RF paths. Each RF path may include the power divider 225, transmission paths, reception paths, and phase shifters. Each transmission path may include a Doherty PA. Each transmission path may include a low noise amplifier (LNA). For example, a first RF path may include a first Doherty PA 240-1, a first LNA 245-1, and a first phase shifter 270-1. A second RF path may include a second Doherty PA 240-2, a second LNA 245-2, and a second phase shifter 270-2. A third RF path may include a third Doherty PA 240-3, a third LNA 245-3, and a third phase shifter 270-3. A fourth RF path may include a fourth Doherty PA 240-4, a fourth LNA 245-4, and a fourth phase shifter 270-4. A fifth RF path may include a fifth Doherty PA 240-5, a fifth LNA 245-5, and a fifth phase shifter 270-5. A sixth RF path may include a sixth Doherty PA 240-6, a sixth LNA 245-6, and a sixth phase shifter 270-6. A seventh RF path may include a seventh Doherty PA 240-7, a seventh LNA 245-7, and a seventh phase shifter 270-7. An eighth RF path may include an eighth Doherty PA 240-8, an eighth LNA 245-8, and an eighth phase shifter 270-8.

The component 230 may be connected to a plurality of antennas. Each RF path of the component 230 may be connected to an antenna. For example, the first RF path may be connected to a first antenna 250-1. The second RF path may be connected to a second antenna 250-2. The third RF path may be connected to a third antenna 250-3. The fourth RF path may be connected to a fourth antenna 250-4. The fifth RF path may be connected to a fifth antenna 250-5. The sixth RF path may be connected to a sixth antenna 250-6. The seventh RF path may be connected to a seventh antenna 250-7. The eighth RF path may be connected to an eighth antenna 250-8.

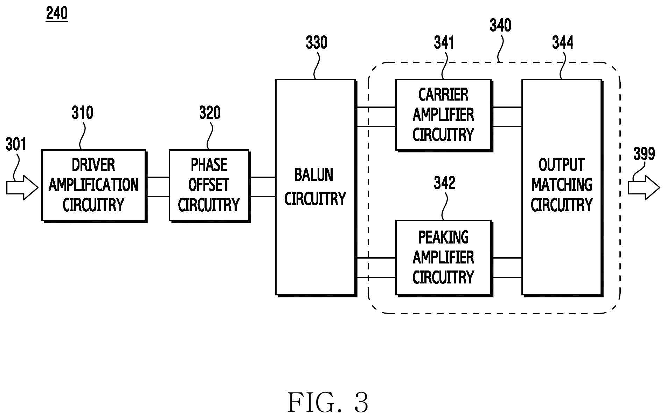

In FIGS. 2B, 2C, and 2D, a RF path on which the Doherty PA of various example embodiments of the present disclosure is disposed has been described. The RF path illustrated in FIGS. 2B, 2C, and 2D is merely an example for describing transmission process of the RF signal to the PA and the antenna. FIGS. 2B, 2C, and 2D and their descriptions are not to be construed as excluding RF processing circuitry having a structure different from those illustrated in FIGS. 2B, 2C, and 2D from the embodiments. In addition, FIGS. 2B, 2C, and 2D are merely examples for explaining the RF path, and are not construed as limiting an implementation method of the Doherty PA of the present disclosure. For example, circuitry including the Doherty PA may be disposed on a substrate (e.g., a PCB) in an electronic device (e.g., the base station 110, the terminal 120, the lower network node 220), or may be implemented as a component (e.g., a power amplifier module (PAM), RFIC). For example, the RFIC (e.g., beamforming RFIC, monolithic microwave integrated circuitry (MMIC) MMU RFIC, mmWave RFIC) may include a plurality of RF paths, and each RF path may include a Doherty PA. Hereinafter, example circuitry of Doherty PA according to various example embodiments will be described in greater detail below with reference to FIGS. 3, 4A, 4B, 5 and 6.

An electronic device transmitting a signal through a wireless channel may be configured to amplify a signal and transmit the amplified signal through an antenna. In signal amplification, a differential amplifier may be used to reduce noise components and provide high gains. In addition, since communication technology such as long term evolution (LTE) technology and 5G new radio (NR) uses an OFDM method, high peak-to-average power ratio (PAPR) may occur. In order to reduce loss of a peak signal, it may be required to operate in an area backed off as much as the PAPR from the maximum output power. In this case, efficiency of the PA may be reduced. In order to overcome the reduction in efficiency, a Doherty PA may be used.

According to various embodiments of the present disclosure, an electronic device (e.g., the base station 110, the terminal 120, or a network entity (e.g., the lower network node 220, a repeater) related to the base station 110) may include a two-stage Doherty PA having a differential mode. In the present disclosure, a design structure of circuitry for reducing insertion loss and/or path loss by simplifying components of the two-stage Doherty PA in differential mode is described. In the present disclosure, a term "Doherty amplifier" may refer, for example, to circuitry using carrier amplifier circuitry and peaking amplifier circuitry. In circuitry including a driver amplifier and a Doherty amplifier, a term 'two-stage' of the present disclosure may refer, for example, to a first stage corresponding to a driver amplifier and a second stage corresponding to a Doherty amplifier. The term 'two-stage' may be used interchangeably with dual, double, and/or equivalent technical terms.

FIG. 3 illustrates an example of components of a two-stage Doherty PA. In FIG. 3, an example of a Doherty PA 240-2, ..., and a Doherty PA 240-N is illustrated. A two-stage Doherty PA described below from FIG. 3 illustrates an example of the Doherty PA of FIGS. 2B, 2C, and 2D.

Referring to FIG. 3, a differential two-stage Doherty PA 240 may provide an RF output signal (RFₒᵤₜ) 399 by amplifying an RF input signal (RFᵢₙ) 301. For example, the RF output signal 399 may be transmitted to the outside through an antenna (e.g., the antenna 250-i). The differential two-stage Doherty PA 240 may include driver amplification circuitry 310, phase offset circuitry 320, balun circuitry 330, and Doherty amplification circuitry 340.

The Doherty amplification circuitry 340, which includes main amplification circuitry, may include a Doherty PA. For example, the Doherty amplification circuitry 340 may include carrier amplifier circuitry 341, peaking amplifier circuitry 342, and output matching circuitry 344. The carrier amplifier circuitry 341 may include a carrier amplifier (e.g., a transistor, a stack FET). According to an embodiment, the carrier amplifier circuitry 341 may include a differential amplifier. The peaking amplifier circuitry 342 may include a peaking amplifier (e.g., a transistor, a stack FET). According to an embodiment, the peaking amplifier circuitry 342 may include a differential amplifier. The carrier amplifier may be referred to as a main amplifier. The peaking amplifier may be referred to as an auxiliary amplifier. The output matching circuitry 344 may include at least one element for matching between output of the carrier amplifier circuitry 341 and output of the peaking amplifier circuitry 342. The output matching circuitry 344 may provide an RF output signal 399 by combining the output of the carrier amplifier circuitry 341 and the output of the peaking amplifier circuitry 342. In general, at low output, the carrier amplifier operates to maintain high efficiency, and at high output, two amplifiers, that is, the carrier amplifier and the peaking amplifier, may operate in parallel. In general, the carrier amplifier may be an amplifier of AB class (operation point moves to A class bias) or B class (operation point at a blocking point of a transistor). The peaking amplifier, which is generally a C class (operation point below the blocking point of the transistor) amplifier, may form a lot of distortion. For example, as input power is included, the peaking amplifier may operate. As the bias is adjusted so that the formed distortion and a distortion of the carrier amplifier offset each other out, linearity may be maintained. The Doherty amplifier circuitry 340 may include a structure for connecting the carrier amplifier and the peaking amplifier. A load modulation technique or an active load pull technique by an output power of the peaking amplifier may be used as a basic operating principle of the Doherty amplifier circuitry 340. For example, the load modulation technique may provide efficiency improvement in a back-off area by modulating a load impedance according to the output power.

The driver amplification circuitry 310 may be used to drive signals to be applied to the carrier amplifier circuitry 341 and the peaking amplifier circuitry 342 of the Doherty amplification circuitry 340. According to an embodiment, the driver amplification circuitry 310 may include a differential amplifier. The driver amplification circuitry 310 may be connected to the Doherty amplification circuitry 340 through the phase offset circuitry 320 and the balun circuitry 330. In terms of being disposed between the driver amplification circuitry 310 and the Doherty amplification circuitry 340, the phase offset circuitry 320 and the balun circuitry 330 may be referred to as inter-stage network circuitry, network circuitry, internetwork circuitry, connection network circuitry, connection circuitry, inter-stage circuitry, and/or equivalent technical terms.

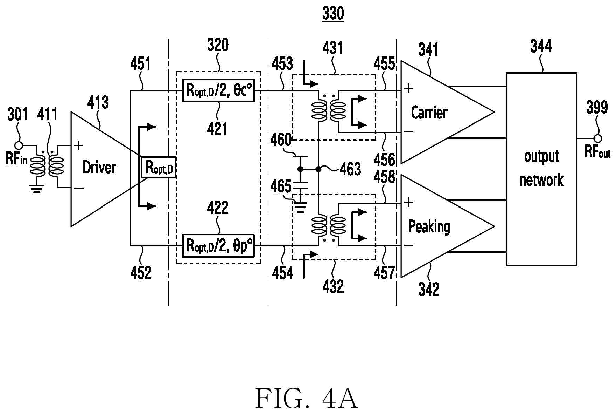

As communication technology advances, development of a power amplifier in highpower, high-efficiency, and high- linearity (e.g., CMOS/Si power amplifier) is required. For example, in a mmWave band (e.g., FR2 band of 3GPP NR) (e.g., 28GHz and 39GHz), a differential amplifier may be used in a high frequency band for reducing a source degeneration effect of a transistor and applying a cross-coupled structure in a high frequency band. In order to obtain high efficiency, a differential two-stage Doherty PA 240 may be used. For example, in order to improve link budget and overall power consumption of a communication device (e.g., the base station 110), the communication device may include the Doherty PA 240 in each transmission path. There are various design methods for designing amplifier circuitry in two-stage, while including an amplifier in differential mode. If the driver amplification circuitry 310 includes each of an amplifier for an inversion input and an amplifier for a non-inversion input, a power divider (e.g., Wilkinson power divider) (or a coupler) for each amplifier and a transformer for each path of the distributor may be required. For example, four differential amplifiers and five transformers are required. However, power divider and coupler have disadvantage that losses increase as the frequency increases, and are not suitable for the miniaturization trend. In addition, it is not easy to design a power divider (or hybrid coupler) to generate two differential signals to have an output signal of a constant amplitude and/or phase, which may cause a performance degradation of the PA. In order to address the described- above problem, the differential two-stage Doherty PA 240 according to various example embodiments of the present disclosure may include a circuitry structure in which one PA of the driver amplification circuitry 310 is connected to the Doherty amplification circuitry 340 through the phase offset circuitry 320 and the balun circuitry 330 instead of the power divider or coupler. The gain improvement and the miniaturization of chip size may be achieved through the differential two-stage Doherty PA 240. Hereinafter, examples of the phase offset circuitry 320 and the balun circuitry 330 will be described in greater detail with reference to FIGS. 4A, 4B, 5 and 6.

FIG. 4A illustrates an example of a two-stage Doherty PA (e.g., differential two-stage Doherty PA 240) including phase offset circuitry (e.g., phase offset circuitry 320) in a single-ended scheme.

Referring to FIG. 4A, a differential two-stage Doherty PA 240 may include driver amplification circuitry 310. The driver amplification circuitry 310 may include a single differential amplifier. For example, the driver amplification circuitry 310 may include balun circuitry 411 and a driver amplifier 413. An RF input signal (RFᵢₙ) 301 may be distributed into a first input signal and a second input signal through the balun circuitry 411. The first input signal may be input to a non-inversion terminal (+) of the driver amplifier 413, and the second input signal may be input to an inversion terminal (-) of the driver amplifier 413. For example, the driver amplifier 413 may include an FET for the inversion terminal and an FET for the non-inversion terminal. The driver amplifier 413 may provide a first output signal 451 and a second output signal 452 based on the first input signal and the second input signal. For example, due to the balun circuitry 411 of the driver amplifier 413, a phase difference between the first output signal 451 and the second output signal 452 may be about 180-degrees.

The differential two-stage Doherty PA 240 may include phase offset circuitry 320. For load modulation of the Doherty amplification circuitry 340, the phase offset circuitry 320 may include lines (e.g., a first line 421 and a second line 422) for causing a phase difference of about 90 degrees to each of an input of carrier amplifier circuitry 341 and an input of peaking amplifier circuitry 342. For example, the phase offset circuitry 320 may include a first line 421 and a second line 422. The first line 421 may be connected to the driver amplifier 413. The second line 422 may be connected to the driver amplifier 413. The first line 421 may provide a first single-ended signal 453 to the first output signal 451 of the driver amplifier 413 through a first phase delay (e.g., θ_{c}) (e.g., phase maintenance, which is a phase shift close to about 0 degree without a substantial phase delay, is also included in an embodiment of the present disclosure). The second line 422 may provide a second single-ended signal 454 to the second output signal 452 of the driver amplifier 413 through a second phase delay (e.g., èₚ₎. A difference between a phase of the first single-ended signal 453 and a phase of the second single-ended signal 454 may be about 90 degrees (or about -90 degrees). The phase offset circuitry 320 may include the first line 421 and the second line 422 configured such that a difference between the phase of the first single-ended signal 453 and the phase of the second single-ended signal 454 becomes about 90 degrees (or about -90 degrees). The first line 421 may correspond to a signal path for the carrier amplifier circuitry 341. The second line 422 may correspond to a signal path for the peaking amplifier circuitry 342. For example, an impedance toward the phase offset circuitry 320 from the driver amplification circuitry 310 may be R_{opt,D}. The first line 421 may have an impedance of about R_{opt,D} /2, and may provide a phase delay of θ_{c}. The second line 422 may have an impedance of about R_{opt,D} /2, and may provide a phase delay of θₚ. A difference between θ_{c} and θₚ may be about -90 degrees (or about 90 degrees).

The balun circuitry 330 may be disposed between the phase offset circuitry 320 and the Doherty amplification circuitry 340. The balun circuitry 330 may be configured to output signals from the phase offset circuitry 320 configured in a single-ended scheme in a differential scheme. For example, the balun circuitry 330 may include first balun circuitry 431 and second balun circuitry 432. The first balun circuitry 431 may be configured to connect unbalance circuitry (e.g., the phase offset circuitry 320) configured in a single-ended scheme and balance circuitry (e.g., the carrier amplifier circuitry 341) configured in a differential scheme. The second balun circuitry 432 may be configured to connect unbalance circuitry (e.g., the phase offset circuitry 320) configured in a single-ended scheme and balance circuitry (e.g., the peaking amplifier circuitry 342) configured in a differential scheme.

The first balun circuitry 431 may include a transformer. A primary end of the transformer may include a first input port and a first ground port. A secondary terminal of the transformer may include a first carrier input port and a second carrier input port. The second balun circuitry 432 may include a transformer. A primary end of the transformer may include a second input port and a second ground port. A secondary end of the transformer may include a first peaking input port and a second peaking input port. According to an embodiment, the first ground port and the second ground port may be connected to a node 463. Each of the first ground port and the second ground port may be electrically connected to the ground through the node 463. For example, the first ground port and the second ground port may be shorted at the node 463. A capacitor 465 for operating as a bypass capacitor may be connected to the node 463. The capacitor 465 may be connected to the ground. According to an embodiment, a drain voltage 460 (e.g., Vdd) may be supplied through the node 463. For example, the drain voltage 460 may be supplied to a drain of a FET (e.g., a non-inversion FET) of the driver amplifier 413 through the node 463 and the first balun circuitry 431. The drain voltage 460 may be supplied to a drain of a FET (e.g., an inversion FET) of the driver amplifier 413 through the node 463 and the second balun circuitry 432. Although FIG. 4A illustrates an example in which the first ground port and the second ground port are connected, embodiments of the present disclosure are not limited thereto. For example, the first ground port and the second ground port may be individually connected to the ground. A bypass capacitor for the first ground port and a bypass capacitor for the second ground port may be included in the two-stage Doherty PA 240, respectively.

Signals in a single-ended scheme may be converted into signals in a differential scheme, through the first balun circuitry 431. The converted signals may be transmitted to the carrier amplifier circuitry 341. For example, the first single-ended signal 453 may be converted into a first carrier input signal 455 and a second carrier input signal 456 through the first balun circuitry 431. The first carrier input signal 455 may be input to a non-inversion terminal (+) of a carrier amplifier of the carrier amplifier circuitry 341. The second carrier input signal 456 may be input to an inversion terminal (-) of a carrier amplifier of the carrier amplifier circuitry 341. Signals in a single-ended scheme may be converted into signals in a differential scheme, through the second balun circuitry 432. The converted signals may be transmitted to the peaking amplifier circuitry 342. For example, the second single-ended signal 454 may be converted into a first peaking input signal 457 and a second peaking input signal 458, through the second balun circuitry 432. The first peaking input signal 457 may be input to a non-inversion terminal (+) of a peaking amplifier of the peaking amplifier circuitry 342. The second peaking input signal 458 may be input to an inversion terminal (-) of a peaking amplifier of the peaking amplifier circuitry 342.

The differential two-stage Doherty PA 240 may include Doherty amplification circuitry 340. The Doherty amplification circuitry 340 may include the carrier amplifier circuitry 341, the peaking amplifier circuitry 342, and output matching circuitry 344. The carrier amplifier circuitry 341 may include a differential amplifier. For example, the carrier amplifier circuitry 341 may include first FETs connected to a non-inversion terminal (e.g., a terminal connected to a first carrier input port of the first balun circuitry 431), and second FETs connected to an inversion terminal (e.g., a terminal connected to a second carrier input port of the first balun circuitry 431). For example, the first FETs may be stack FETs connected in series. The second FETs may be stack FETs connected in series. The peaking amplifier circuitry 342 may include a differential amplifier. For example, the peaking amplifier circuitry 342 may include third FETs connected to a non-inversion terminal (e.g., a terminal connected to a first peaking input port of the second balun circuitry 432), and fourth FETs connected to an inversion terminal (e.g., a terminal connected to a second peaking input port of the second balun circuitry 432). For example, the third FETs may be stack FETs connected in series. The fourth FETs may be stack FETs connected in series. The output matching circuitry 344 may combine output of the first FETs, output of the second FETs, output of the third FETs, and output of the fourth FETs. The output matching circuitry 344 may be configured to perform a load modulation according to output power. The output matching circuitry 344 may provide an RF output signal (RFₒᵤₜ) 399 through the outputs.

As illustrated in FIG. 4A, the differential two-stage Doherty PA 240 according to embodiments of the present disclosure may include three differential amplifiers. The driver amplification circuitry 310 may include a differential amplifier. Each of the carrier amplifier circuitry 341 and the peaking amplifier circuitry 342 of the Doherty amplifier circuitry 340, which is a main amplifier stage, may include a differential amplifier. The balun circuitry 330 not only converts signals (e.g., the first single-ended signal 453 and the second single-ended signal 454) of the phase offset circuitry 320 configured in a single-ended scheme into differential signals, but may also function as matching circuitry. For example, the first balun circuitry 431 of the balun circuitry 330 may be used as an input matching circuitry of the carrier amplifier circuitry 341. The second balun circuitry 432 of the balun circuitry 330 may be used as an input matching circuitry for the peaking amplifier circuitry 342.

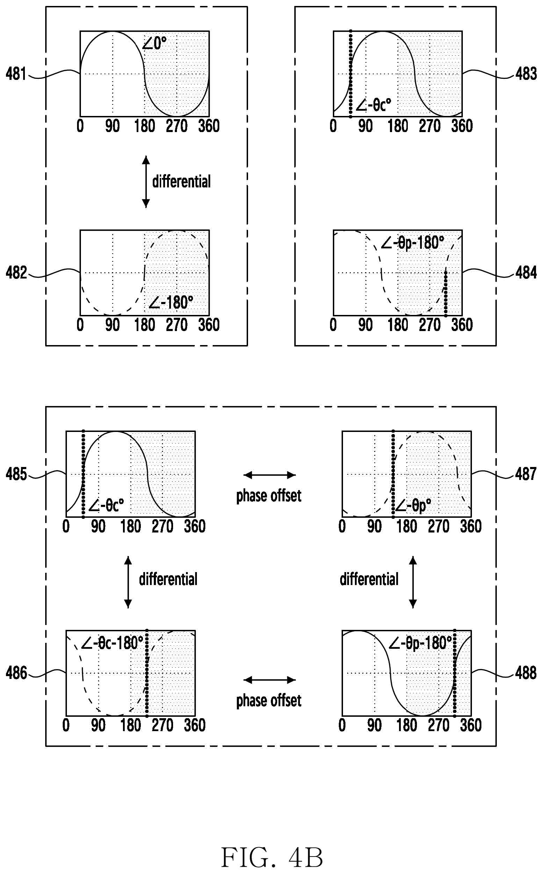

FIG. 4B illustrates a phase for each point of a two-stage Doherty PA. In FIG. 4A, a signal of each path may have an RF waveform corresponding to a point of the corresponding path. The first output signal 451 indicates a signal at a point between the first line 421 connected to the driver amplifier 413 (e.g., a drain of a non-inversion FET). The second output signal 452 indicates a signal at a point between the driver amplifier 413 (e.g., a drain of an inversion FET) and the second line 422. The first single-ended signal 453 indicates a signal at a point between the first line 421 and the first balun circuitry 431. The second single-ended signal 454 indicates a signal at a point between the second line 422 and the second balun circuitry 432. The first carrier input signal 455 indicates a signal at a point between the first balun circuitry 431 and a non-inversion terminal of the carrier amplifier circuitry 341. The second carrier input signal 456 indicates a signal at a point between the first balun circuitry 431 and an inversion terminal of the carrier amplifier circuitry 341. The first peaking input signal 457 indicates a signal at a point between the second balun circuitry 432 and a non-inversion terminal of the peaking amplifier circuitry 342. The second peaking input signal 458 indicates a signal at a point between the second balun circuitry 432 and an inversion terminal of the peaking amplifier circuitry 342.

Referring to FIG. 4B, a first waveform 481 indicates a waveform of the first output signal 451. A second waveform 482 indicates a waveform of the second output signal 452. A third waveform 483 indicates a waveform of the first single-ended signal 453. A fourth waveform 484 indicates a waveform of the second single-ended signal 454. A fifth waveform 485 indicates a waveform of the first carrier input signal 455. A sixth waveform 486 indicates a waveform of the second carrier input signal 456. A seventh waveform 487 indicates a waveform of the first peaking input signal 457. An eighth waveform 488 indicates a waveform of the second peaking input signal 458.

A phase difference between the first waveform 481 and the second waveform 482 may be about 180 degrees or about -180 degrees. Due to the balun circuitry 411 of the driver amplification circuitry 310, output may be inverted by 180 degrees with respect to other outputs. A phase of the third waveform 483 may be delayed by a first phase delay (e.g., about θ_{c}) via the first line 421. A phase of the fourth waveform 484 may be delayed by a second phase delay (e.g., about θₚ) via the second line 422. Accordingly, a phase difference between the third waveform 483 and the fourth waveform 484 may occur by about θₚ+180°-θ_{c}. For a load modulation of the Doherty amplification circuitry 340, a phase difference by about 90 degrees is required between an input of the carrier amplifier circuitry 341 and an input of the peaking amplifier circuitry 342. Considering that a cycle is 360 degrees, a difference (e.g., θₚ-θ_{c}) between the first phase delay and the second phase delay may be about 90 degrees (or about - 90 degrees).

A phase difference between the fifth waveform 485 and the sixth waveform 486 may be about 180 degrees or about -180 degrees. Due to the first balun circuitry 431 of the carrier amplifier circuitry 341, output may be inverted by 180 degrees with respect to other outputs. A phase difference between the seventh waveform 487 and the eighth waveform 488 may be about 180 degrees or about -180 degrees. Due to the second balun circuitry 432 of the peaking amplifier circuitry 342, output may be inverted by 180 degrees with respect to other outputs. The phase difference of 90 degrees due to the phase offset circuitry 320 may be equally applied to signals in differential mode. For example, a phase difference between the fifth waveform 485 and the seventh waveform 487 may correspond to a difference between the first phase delay and the second phase delay (e.g., θₚ-θ_{c}) of the phase offset circuitry 320. For example, a phase difference between the sixth waveform 486 and the eighth waveform 488 may correspond to a difference between the first phase delay and the second phase delay (e.g., θₚ-θ_{c}) of the phase offset circuitry 320.

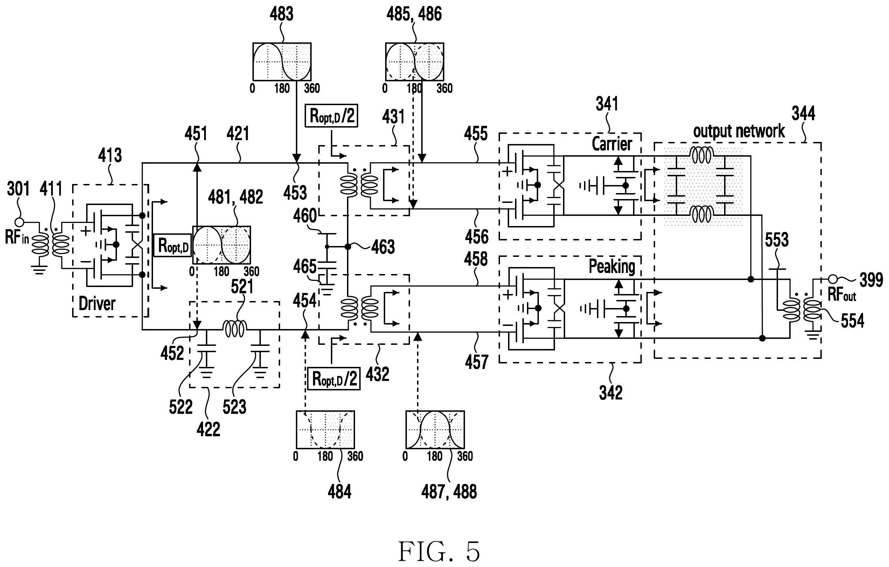

FIG. 5 illustrates an example of a two-stage Doherty PA (e.g., differential two-stage Doherty PA 240) including phase off circuitry (e.g., phase off set circuitry 320) in a single-ended scheme.

Referring to FIG. 5, a differential two-stage Doherty PA 240 may include driver amplification circuitry 310, phase offset circuitry 320, balun circuitry 330, and Doherty amplification circuitry 340. The driver amplification circuitry 310 may include a driver amplifier 413. The driver amplifier 413 may be a differential amplifier. For example, the driver amplifier 413 may include a first FET for an inversion input and a second FET for a non-inversion input. For the inversion input and the non- inversion input, the driver amplifier 413 may include balun circuitry 411. An RF input signal 301 may be converted into the inversion input and the non- inversion input, through the balun circuitry 411.

The phase offset circuitry 320 may include a first line 421 having a first phase delay and a second line 422 having a second phase delay. As described with reference to FIG. 4B, for a load modulation of the Doherty amplification circuitry 340, a difference between the first phase delay and the second phase delay may have size of about 90 degrees (e.g., including about 90 degrees and about -90 degrees). For the difference of about 90 degrees between the first phase delay and the second phase delay, the first line 421 and the second line 422 may be configured in one of various schemes. According to an embodiment, the first line 421 may include only a simple line, and the second line 422 may include a C-L-C structure. The C-L-C structure may include an inductor 521 corresponding to at least a portion of a transmission line connecting the driver amplification circuitry 310 and the second balun circuitry 432, a first capacitor 522 disposed to the line in parallel, and a second capacitor 523 disposed to the line in parallel. Through the C-L-C structure, a phase delay of about 90 degrees may be caused. Through the C-L-C structure, the phase offset circuitry 320 may provide a difference between a phase of the first single-ended signal 453 and a phase of the second single-ended signal 454 (hereinafter, a phase difference), corresponding to about 90 degrees (or about -90 degrees). The output matching circuitry 344 of FIG. 5 may include a transformer circuitry (transformer). The transformer circuitry may include an input unit 553 and an output unit 554. The output of the carrier amplifier circuit 341 may be provided to the transformer circuitry. The carrier amplifier circuitry 341 may be electrically connected to the input unit 553 of the transformer circuitry. The output of the peaking amplifier circuitry 342 may be provided to the transformer circuitry. The peaking amplifier circuitry 342 may be electrically connected to the input unit 553 of the transformer circuitry. The output unit 554 may output an RF output signal (RFₒᵤₜ) 399.

FIG. 5 illustrates an example in which a C-L-C structure is implemented in the second line 422 in order for a phase difference of about 90 degrees, but embodiments of the present disclosure are not limited thereto. For example, for a phase difference of about 90 degrees, the phase offset circuitry 320 may include a first line 421 including a C-L-C structure and a second line 422 to which a separate element is not connected. For another example, for a phase difference of about 90 degrees, the phase offset circuitry 320 may include a first line 421 including an L-C-L structure and a second line 422 to which a separate element is not connected. For still another example, for a phase difference of about 90 degrees, the phase offset circuitry 320 may include a second line 422 including an L-C-L structure and a first line 421 to which a separate element is not connected. For still another example, the phase offset circuitry 320 may include a first line 421 including an L-C structure having a capacitor connected in parallel with an inductor disposed in series, and a second line 422 to which a separate element is not connected. The L-C structure may provide a phase difference of about 90 degrees between the first line 421 and the second line 422. For still another example, the phase offset circuitry 320 may include a first line 421 including a C-L structure having an inductor connected in series with a capacitor disposed in parallel, and a second line 422 to which a separate element is not connected. The C-L structure may provide a phase difference of about 90 degrees between the first line 421 and the second line 422. For still another example, the phase offset circuitry 320 may include a second line 422 including a C-L structure having an inductor connected in series with a capacitor disposed in parallel, and a first line 421 to which a separate element is not connected.

Impedance matching may affect efficiency of a power amplifier. This is because power is well transmitted through the impedance matching. According to embodiments of the present disclosure, the phase offset circuitry 320 and the balun circuitry 330 may be used for impedance matching. According to an embodiment, the phase offset circuitry 320 may cause only a phase delay without changing magnitude of the impedance. For example, it is assumed that an output impedance of the driver amplification circuitry 310 is matched to R_{opt,D}. Since lines of the phase offset circuitry 320 are all connected in a single-ended scheme, each impedance may be connected in series in terms of viewing from the driver amplification circuitry 310. For example, the first line 421 of the phase offset circuitry 320 may have an impedance of about R_{opt,D} /2. The second line 422 of the phase offset circuitry 320 may have an impedance of about R_{opt,D} /2. This impedance matching may also be applied to the balun circuitry. The first balun circuitry 431 may be configured to provide an output impedance of about R_{opt,D} /2 in the first line 421. The second balun circuitry 432 may be configured to provide an output impedance of about R_{opt,D} /2 in the second line 422.

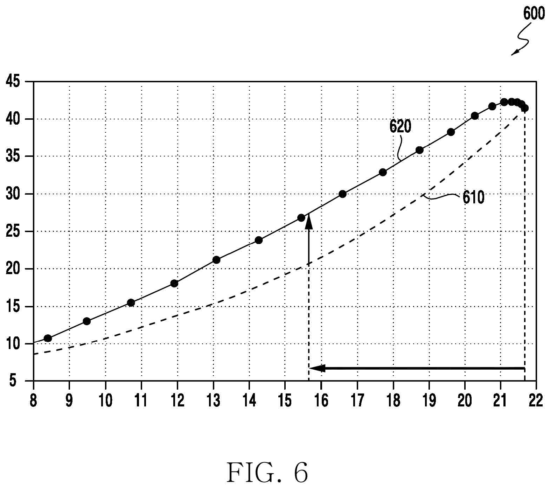

FIG. 6 illustrates an example of performance of a two-stage Doherty PA (e.g., differential two-stage Doherty PA 240) including phase off set circuitry (e.g., phase offset circuitry 320) in a single-ended scheme.

Referring to FIG. 6, a graph 600 indicates power amplifier efficiency (PAE) according to output power. A horizontal axis of the graph 600 indicates output power (unit: decibel milliwatt (dBm)) and a vertical axis indicates PAE (unit: percent). A first line 610 indicates a PAE of a PA of Class AB, and a second line 620 indicates a PAE of a differential two-stage Doherty PA 240. Referring to the first line 610 and the second line 620, it may be confirmed that the PA efficiency of the differential two-stage Doherty PA 240 is improved compared to the PA of Class AB, at a point (e.g., 15.7 dBm) backed off by a certain level (e.g., about 6 dB).

Through a circuitry structure of the differential two-stage Doherty PA 240 described through FIGS. 3, 4A, 4B, 5 and 6 (which may be referred to as FIGS. 3 to 6), loss of unnecessary elements (e.g., 3dB coupler, hybrid coupler, and Wilkinson power divider) may be reduced and gains may be improved. In addition, transmission performance of an electronic component (e.g., RFIC) or an electronic device (e.g., base station 110), which include the circuitry structure, may be improved.

FIG. 7 illustrates an example of components of an electronic device. For example, an electronic device 710 may be one of a base station 110 (or a lower network node 220) and a terminal 120, and an electronic device 720 may be another one of the base station 110 (or the lower network node 220) and the terminal 120. The electronic device 710 may be an antenna device of an RFIC including one or more RF chains. In addition to the PA (e.g., differential two-stage Doherty PA 240) itself described through FIGS. 3 to 6, an electronic device including the PA is also included in embodiments of the present disclosure. In the differential two-stage Doherty PA 240, the electronic device 710 may include phase offset circuitry 320 in a single-ended scheme and balun circuitry 330 for provide output in a differential scheme.

Referring to FIG. 7, an example configuration of the electronic device 710 is illustrated. The electronic device 710 may include an antenna unit (e.g., including at least one antenna) 711, a filter unit (e.g., including at least one filter) 712, a radio frequency (RF) processing unit (e.g., including RF circuitry) 713, and a processor (e.g., including processing circuitry) 714.

The antenna unit 711 may include a plurality of antennas. The antenna performs functions for transmitting and receiving a signal through a wireless channel. The antenna may include a conductor formed on a substrate (e.g., a PCB) or a radiator formed in a conductive pattern. The antenna may radiate an up-converted signal on a wireless channel or obtain a signal radiated by another device. Each antenna may be referred to as an antenna element or an antenna device. According to an embodiment, the antenna unit 711 may include an antenna array in which a plurality of antenna elements form array. The antenna unit 711 may be electrically connected to the filter unit 712 through RF signal lines. The antenna unit 711 may be mounted on a PCB including a plurality of antenna elements. The PCB may include a plurality of RF signal lines connecting each antenna element to a filter of the filter unit 712. These RF signal lines may be referred to as a feeding network. The antenna unit 711 may provide a received signal to the filter unit 712 or may radiate a signal provided from the filter unit 712 into the air.

The filter unit 712 may include at least one filter and perform filtering, in order to transmit a signal of a desired frequency. The filter unit 712 may perform a function of selectively identifying a frequency, by forming a resonance. The filter unit 712 may include at least one of a band pass filter, a low pass filter, a high pass filter, or a band reject filter. In other words, the filter unit 712 may include RF circuitry for obtaining a signal in a frequency band for transmission or a frequency band for reception. The filter unit 712 according to various embodiments may electrically connect the antenna unit 711 to the RF processing unit 713.

The RF processing unit 713 may include a plurality of RF paths including RF circuitry. The RF path may be a unit of a path through which a signal received through an antenna or a signal radiated through the antenna passes. At least one RF path may be referred to as an RF chain. The RF chain may include a plurality of RF devices. The RF devices may include an amplifier, a mixer, an oscillator, a digital-to-analog converter (DAC), an analog-to-digital converter (ADC), and the like. For example, the RF processing unit 713 may include an up-converter that up-converts a digital transmission signal of a baseband into a transmission frequency, and a DAC that converts the up-converted digital transmission signal into an analog RF transmission signal. The up converter and the DAC form a portion of a transmission path. The transmission path may further include a power amplifier (PA) or a coupler (or a combiner). In addition, for example, the RF processing unit 713 may include the ADC that converts an analog RF reception signal into a digital reception signal and a down converter that converts the digital reception signal into a digital reception signal of the baseband. The ADC and the down converter form a portion of a reception path. The reception path may further include a low-noise amplifier (LNA) or a coupler (or a divider). RF components of the RF processing unit may be implemented on a PCB. For example, the electronic device 710 may include a structure in which the antenna unit 711 to the filter unit 712 to the RF processing unit 713 are stacked in this order. For example, the antennas and the RF components of the RF processing unit may be implemented on a PCB. For example, filters may be repeatedly fastened between PCBs to form a plurality of layers.

The RF processing unit 713 may include a plurality of RF processing chains for a plurality of signal paths transmitted to the antenna unit 111 and the filter unit 712. For example, the RF processing unit 713 may be RFIC. The RFIC may include a plurality of RF processing chains. A signal applied in the baseband may be input to the RFIC. The signal input to the RFIC may be distributed to each antenna element. In this case, for beamforming, an independent phase shift may be applied to each of the antenna elements. Accordingly, the RFIC may include RF processing chains for processing a signal to be transmitted to each antenna element. Each RF processing chain may include one or more RF components for RF signal processing. The RF processing unit 713 may include driver amplification circuitry 310, phase offset circuitry 320, balun circuitry 330, and Doherty amplification circuitry 340. According to an embodiment, the phase offset circuitry 320 may be configured to provide a phase difference of about 90 degrees between two signals from the driver amplification circuitry 310. For example, a difference between a phase delay of a first line (e.g., the first line 421) and a phase delay of a second line (e.g., the second line 422) of the phase offset circuitry 320 may be about 90 degrees. The difference of about 90 degrees may enable an efficient load modulation in the Doherty amplification circuitry 340.

The processor 714 may include various processing circuitry and control overall operations of the electronic device 710. The processor 714 may include various modules for performing communication. The processor 714 may include at least one processor such as a modem. The processor 714 may include modules for digital signal processing. For example, the processor 714 may include a modem. When transmitting data, the processor 714 generates complex symbols by encoding and modulating a transmission bit string. In addition, for example, when receiving data, the processor 714 restores a reception bit string by demodulating and decoding a baseband signal. The processor 714 may perform functions of a protocol stack required by a communication standard. The processor 714 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

In FIG. 7, functional configuration of an electronic device 1010 is described as a device in which the Doherty PA of the present disclosure may be utilized. However, an example illustrated in FIG. 7 is merely an example configuration for the use of the Doherty PA described in FIGS. 1 to 6, and embodiments of the present disclosure are not limited to the components illustrated in FIG. 7. RF module, MMIC, PAM, RFIC, communication equipment with another configuration that include the Doherty PA with the described above resistance selection circuit, or a structure for the Doherty PA may also be understood as an embodiment of the present disclosure.

Whether embodiments of the present disclosure are implemented may be confirmed in various ways. For example, in the differential two-stage Doherty PA 240, Whether embodiments of the present disclosure are implemented may be confirmed via an arrangement of the phase offset circuitry 320 directly connected to the driver amplification circuitry 310. Whether embodiments of the present disclosure are implemented may be confirmed via an arrangement in which the phase offset circuitry 320 is not directly connected to an input terminal of the Doherty amplification circuitry 340, but is connected through the balun circuitry 330. Whether embodiments of the present disclosure are implemented may be confirmed, via a structure in which the phase offset circuitry 320 and the balun circuitry 330 are arranged without a separate power divider (e.g., Wilkinson power divider) or coupler (e.g., 3dB hybrid coupler) between the driver amplification circuitry 310 and the Doherty amplification circuitry 340, in the differential two-stage Doherty PA 240. Whether embodiments of the present disclosure are implemented may be confirmed, via the node 463 in which the first balun circuitry 431 connected to the carrier amplifier circuitry 341 and the second balun circuitry 432 connected to the peaking amplifier circuitry 342 are shorted, in the differential two-stage Doherty PA 240. Whether embodiments of the present disclosure are implemented may be confirmed, via the number of differential amplifiers included in a transmission path within the RFIC being three. Whether embodiments of the present disclosure are implemented may be confirmed, via the number of transformers included in the transmission path within the RFIC being three.

In various example embodiments, circuitry is provided. The circuitry may comprise driver amplification circuitry, phase offset circuitry, balun circuitry, carrier amplifier circuitry, and peaking amplifier circuitry. The phase offset circuitry may comprise a first line connected to the driver amplification circuitry and configured to provide a first single-ended signal having a first phase delay. The phase offset circuitry may comprise a second line connected to the driver amplification circuitry and configured to provide a second single-ended signal having a second phase delay different from the first phase delay of the first single-ended signal of the first line. The balun circuitry may comprise a first balun circuitry connected between the first line and the carrier amplifier circuitry, and a second balun circuitry connected between the second line and the peaking amplifier circuitry.

In various example embodiments, an electronic component is provided. The electronic component may comprise a power divider and a plurality of radio frequency (RF) paths, and each of the plurality of RF paths may comprise a phase shifter and a power amplifier. The power amplifier may comprise driver amplification circuitry, phase offset circuitry, balun circuitry, carrier amplifier circuitry, and peaking amplifier circuitry. The phase offset circuitry may comprise a first line and a second line that connect the driver amplification circuitry and the balun circuitry. The balun circuitry may comprise a first transformer for the carrier amplifier circuitry and a second transformer for the peaking amplifier circuitry. The first line may be configured to provide a first single-ended signal to the first transformer. The second line may be configured to provide a second single-ended signal to the second transformer.

In various example embodiments, an electronic device is provided. The electronic device may comprise a plurality of antennas, radio frequency integrated circuitry (RFIC) for the plurality of antennas, and a processor. The RFIC may comprise a power divider and a plurality of RF paths. Each of the plurality of RF paths may comprise a phase shifter and a power amplifier. The power amplifier may comprise driver amplification circuitry, phase offset circuitry, balun circuitry, carrier amplifier circuitry, and peaking amplifier circuitry. The phase offset circuitry may comprise lines connecting the driver amplification circuitry and the balun circuitry. The balun circuitry may comprise a first transformer for the carrier amplifier circuitry and a second transformer for the peaking amplifier circuitry. A first line of the lines may be configured to provide a first single-ended signal to the first transformer. A second line of the lines may be configured to provide a second single-ended signal to the second transformer.

In various example embodiments, a differential two-stage Doherty PA is provided. The differential two-stage Doherty PA may comprise driver amplification circuitry, phase offset circuitry, balun circuitry, and Doherty amplification circuitry including carrier amplifier circuitry and peaking amplifier circuitry. The phase off set circuitry may be connected to a first line connected to the driver amplification circuitry in a single-ended scheme and the driver amplification circuitry in a single-ended scheme. A second line providing a second phase delay different from a first phase delay of the first line may be included. The balun circuitry may include first balun circuitry connected to the first line and the carrier amplifier circuitry and second balun circuitry connected to the second line and the peaking amplifier circuitry.

According to an example embodiment, the first line of the phase offset circuitry may provide the first single-ended signal corresponding to a first output signal of the driver amplification circuitry. The second line of the phase offset circuitry may provide the second single-ended signal corresponding to a second output signal of the driver amplification circuitry. A phase difference between the first single-ended signal and the second single-ended signal may correspond to 90-degree.

According to an example embodiment, the first balun circuitry may comprise a first transformer having a first input port for obtaining the first single-ended signal, a first ground port, and a first carrier input port and a second carrier input port connected to the carrier amplifier circuitry. The second balun circuitry may comprise a second transformer having a second input port for obtaining the second single-ended signal, a second ground port, and a first peaking input port and a second peaking input port connected to the peaking amplifier circuitry.

According to an example embodiment, the first ground port and the second ground port may be shorted at one node. Each of the first ground port and the second ground port may be electrically connected to the ground through a capacitor connected to the one node.

According to an example embodiment, the carrier amplifier circuitry may comprise a plurality of first field effect transistors (FETs) connected to the first carrier input port and a plurality of second FETs connected to the second carrier input port. The peaking amplifier circuitry may comprise a plurality of third FETs connected to the first peaking input port and a plurality of fourth FETs connected to the second peaking input port.

According to an example embodiment, the driver amplification circuitry may comprise a balun circuitry for a radio frequency (RF) input signal, and a driver amplifier comprising a first field effect transistor (FET) connected to a first output of the balun circuitry and a second FET connected to a second output of the balun circuitry.

According to an example embodiment, a drain voltage for the drain of the first FET may be provided through the one node and the ground port of the first balun circuitry. A drain voltage for the drain of the second FET may be provided through the one node and the ground port of the second balun circuitry.

According to an example embodiment, the first balun circuitry may be configured to match a first input impedance of the carrier amplifier circuitry to an impedance of a specified magnitude. The second balun circuitry may be configured to match a second input impedance of the peaking amplifier circuitry to the impedance of the specified magnitude. The specified magnitude may correspond to a half of magnitude of an impedance from the driver amplification circuitry to the offset circuitry.

According to an example embodiment, the second line, in a C-L-C structure, may comprise a first capacitor disposed in parallel, a second capacitor disposed in parallel, and an inductor disposed in series between the first capacitor and the second capacitor.

According to an example embodiment, the first line may be connected to a first output of the driver amplification circuitry in differential mode. The second line may be connected to a second output of the driver amplification circuitry in differential mode.

In various example embodiments, an electronic component is provided. The electronic component may comprise a power divider, and a plurality of radio frequency (RF) paths. Each of the plurality of RF paths may comprise a phase shifter and a power amplifier. The power amplifier may comprise driver amplification circuitry, phase offset circuitry, balun circuitry, and Doherty amplification circuitry including carrier amplifier circuitry and peaking amplifier circuitry. The phase offset circuitry may comprise a first line and a second line that connect the driver amplification circuitry and the balun circuitry in a single-ended scheme. The balun circuitry may comprise a first transformer for the carrier amplifier circuitry and a second transformer for the peaking amplifier circuitry.

According to an example embodiment, the first line of the phase offset circuitry may provide the first single-ended signal corresponding to a first output signal of the driver amplification circuitry. The second line of the phase offset circuitry may provide the second single-ended signal corresponding to a second output signal of the driver amplification circuitry. A phase difference between the first single-ended signal and the second single-ended signal may correspond to 90-degrees.

According to an example embodiment, the first transformer may comprise a first input port for obtaining the first single-ended signal, a first ground port, and a first carrier input port and a second carrier input port connected to the carrier amplifier circuitry. The second transformer may comprise a second input port for obtaining the second single-ended signal, a second ground port, and a first peaking input port and a second peaking input port connected to the peaking amplifier circuitry.

According to an example embodiment, the first ground port and the second ground port may be shorted at one node. Each of the first ground port and the second ground port may be electrically connected to the ground through a capacitor connected to the one node.

According to an example embodiment, the carrier amplifier circuitry may comprise a plurality of first field effect transistors (FETs) connected to the first carrier input port and a plurality of second FETs connected to the second carrier input port. The peaking amplifier circuitry may comprise a plurality of third FETs connected to the first peaking input port and a plurality of fourth FETs connected to the second peaking input port.

According to an example embodiment, the driver amplification circuitry may comprise a transformer for a radio frequency (RF) input signal, and a driver amplifier comprising a first field effect transistor (FET) connected to the first output of the transformer and a second FET connected to a second output of the transformer.

According to an example embodiment, a drain voltage for the drain of the first FET may be provided through the one node and the ground port of the first transformer. A drain voltage for the drain of the second FET may be provided through the one node and the ground port of the second transformer.

According to an example embodiment, the second line, in a C-L-C structure, may comprise a first capacitor disposed in parallel, a second capacitor disposed in parallel, and an inductor disposed in series between the first capacitor and the second capacitor.

According to an example embodiment, the first line may be connected to a first output of the driver amplification circuitry in differential mode. The second line may be connected to a second output of the driver amplification circuitry in differential mode.

In various example embodiments, an electronic device is provided. The electronic device may comprise a plurality of antennas, radio frequency integrated circuitry (RFIC) for the plurality of antennas, and a processor. The RFIC may comprise a power divider and a plurality of RF paths. Each of the plurality of RF paths may comprise a phase shifter and a power amplifier. The power amplifier may comprise driver amplification circuitry, phase offset circuitry, balun circuitry, and Doherty amplification circuitry including carrier amplifier circuitry and peaking amplifier circuitry. The phase offset circuitry may comprise lines connecting the driver amplification circuitry and the balun circuitry in a single-ended scheme. The balun circuitry may comprise a first transformer for the carrier amplifier circuitry and a second transformer for the peaking amplifier circuitry.

In one or more embodiments, at least one of components described in one or more of the preceding drawings may be configured to perform one or more operations, techniques, processes, and/or methods as described in the present disclosure. For example, a processor (e.g., baseband processor) described above in the present disclosure, related to one or more of the preceding drawings, may be configured to operate according to one or more examples described in the present disclosure. For another example, circuitry associated with user equipment (UE), base station, network element as described above in relation to one or more of the previous drawings may be configured to operate according to one or more examples described herein.

Any of various example embodiments described above may be combined with any other embodiment (or combination of embodiments) unless otherwise explicitly stated. The above-described description of one or more implementations provides examples and explanations, but is not intended to limit the scope of the embodiments to a precise form disclosed. Modifications and variations may be possible according to the guidance, or may be obtained from various embodiments.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), the element may be coupled with the other element directly (e.g., wiredly), wirelessly, or via a third element.

Methods according to embodiments described in claims or the present disclosure may be implemented as a form of hardware, software, or a combination of hardware and software.

In case of implementing as software, a computer-readable storage medium for storing one or more programs (software module) may be provided. One or more programs stored in the computer-readable storage medium are configured for execution by one or more processors in an electronic device. One or more programs include instructions that cause the electronic device to execute methods according to embodiments described in claims or the present disclosure. The one or more programs may be provided by being included in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Such a program (software module, software) may be stored in a random access memory, a non-volatile memory including a flash memory, a read only memory (ROM), an electrically erasable programmable read only memory (EEPROM), a magnetic disc storage device, a compact disc-ROM (CD-ROM), digital versatile discs (DVDs), another type of optical storage device, or a magnetic cassette. Alternatively, it may be stored in a memory including a combination of some or all of them. In addition, a plurality of each configuration memory may be included.

Additionally, a program may be stored in an attachable storage device that may be accessed through a communication network such as the Internet, Intranet, local area network (LAN), wide area network (WAN), or storage area network (SAN), or a combination of them. Such a storage device may be connected to a device performing an embodiment of the present disclosure through an external port. In addition, a separate storage device on the communication network may also access a device that performs embodiment of the present disclosure.

In various example embodiments of the present disclosure described above, an element included in the disclosure are represented in singular or plural numbers according to a specific embodiment presented. However, singular or plural expressions are selected to suit the presented situation for convenience of explanation, the present disclosure is not limited to singular or plural components, and even a component represented in the plural may include a singular number, or a component represented in the singular may include a plural number.

According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. Circuitry, comprising:
driver amplification circuitry;
phase offset circuitry;
balun circuitry;
carrier amplifier circuitry; and
peaking amplifier circuitry,
wherein the phase offset circuitry comprises:
a first line connected to the driver amplification circuitry and configured to provide a first single-ended signal having a first phase delay, and
a second line connected to the driver amplification circuitry and configured to provide a second single-ended signal having a second phase delay different from the first phase delay of the first single-ended signal of the first line, and
wherein the balun circuitry comprises:
first balun circuitry connected between the first line and the carrier amplifier circuitry; and
second balun circuitry connected between the second line and the peaking amplifier circuitry.

2. The circuitry of claim 1,
wherein the first line of the phase offset circuitry is configured to provide the first single-ended signal corresponding to a first output signal of the driver amplification circuitry,
wherein the second line of the phase offset circuitry is configured to provide the second single-ended signal corresponding to a second output signal of the driver amplification circuitry, and
wherein a phase difference between the first single-ended signal and the second single-ended signal corresponds to 90-degrees.

3. The circuitry of claim 2,
wherein the first balun circuitry comprises a first transformer having a first input port for obtaining the first single-ended signal, a first ground port, and a first carrier input port and a second carrier input port connected to the carrier amplifier circuitry, and
wherein the second balun circuitry comprises a second transformer having a second input port for obtaining the second single-ended signal, a second ground port, and a first peaking input port and a second peaking input port connected to the peaking amplifier circuitry.

4. The circuitry of claim 3,
wherein the first ground port and the second ground port are shorted at one node, and
wherein each of the first ground port and the second ground port is electrically connected to the ground through a capacitor connected to the one node.

5. The circuitry of claim 4,
wherein the carrier amplifier circuitry comprises a plurality of first field effect transistors (FETs) connected to the first carrier input port and a plurality of second FETs connected to the second carrier input port, and
wherein the peaking amplifier circuitry comprises a plurality of third FETs connected to the first peaking input port and a plurality of fourth FETs connected to the second peaking input port.

6. The circuitry of claim 5,
wherein the driver amplification circuitry comprises;
balun circuitry for a radio frequency (RF) input signal, and
a driver amplifier comprising a first field effect transistor (FET) connected to a first output of the balun circuitry and a second FET connected to a second output of the balun circuitry,

7. The circuitry of claim 6,
wherein a drain voltage for the drain of the first FET is provided through the one node and the ground port of the first balun circuitry, and
wherein a drain voltage for the drain of the second FET is provided through the one node and the ground port of the second balun circuitry.

8. The circuitry of claim 3,
wherein the first balun circuitry is configured to match a first input impedance of the carrier amplifier circuitry to an impedance having a specified magnitude,
wherein the second balun circuitry is configured to match a second input impedance of the peaking amplifier circuitry to the impedance having the specified magnitude, and
wherein the specified magnitude corresponds to a half of magnitude of an impedance from the driver amplification circuitry to the offset circuitry,

9. The circuitry of claim 1,
wherein the second line, in a capacitor-inductor-capacitor (C-L-C) structure, comprises a first capacitor disposed in parallel, a second capacitor disposed in parallel, and an inductor disposed in series between the first capacitor and the second capacitor.

10. The circuitry of claim 1,
wherein the first line is connected to a first output of the driver amplification circuitry in differential mode, and
wherein the second line is connected to a second output of the driver amplification circuitry in differential mode.

11. An electronic component, comprising:
a power divider comprising circuitry; and
a plurality of radio frequency (RF) paths comprising RF circuitry,
wherein each of the plurality of RF paths comprises a phase shifter and a power amplifier,
wherein the power amplifier comprises driver amplification circuitry, phase offset circuitry, balun circuitry, carrier amplifier circuitry, and peaking amplifier circuitry,
wherein the phase offset circuitry comprises a first line and a second line that connect the driver amplification circuitry and the balun circuitry,
wherein the balun circuitry comprises a first transformer for the carrier amplifier circuitry and a second transformer for the peaking amplifier circuitry,
wherein the first line is configured to provide a first single-ended signal to the first transformer, and
wherein the second line is configured to provide a second single-ended signal to the second transformer.

12. The electronic component of claim 11,
wherein the first line of the phase offset circuitry is configured to provide the first single-ended signal corresponding to a first output signal of the driver amplification circuitry,
wherein the second line of the phase offset circuitry is configured to provide the second single-ended signal corresponding to a second output signal of the driver amplification circuitry, and
wherein a phase difference between the first single-ended signal and the second single-ended signal corresponds to 90-degrees.

13. The electronic component of claim 12,
wherein the first transformer comprises a first input port for obtaining the first single-ended signal, a first ground port, and a first carrier input port and a second carrier input port connected to the carrier amplifier circuitry, and
wherein the second transformer comprises a second input port for obtaining the second single-ended signal, a second ground port, and a first peaking input port and a second peaking input port connected to the peaking amplifier circuitry.

14. The electronic component of claim 13,
wherein the first ground port and the second ground port are shorted at one node, and
wherein each of the first ground port and the second ground port is electrically connected to the ground through a capacitor connected to the one node.

15. An electronic device, comprising:
a plurality of antennas;
radio frequency integrated circuitry (RFIC) for the plurality of antennas; and
at least one processor, comprising processing circuitry,
wherein the RFIC comprises a power divider comprising circuitry and a plurality of RF paths,
wherein each of the plurality of RF paths comprises a phase shifter and a power amplifier,
wherein the power amplifier comprises driver amplification circuitry, phase offset circuitry, balun circuitry, carrier amplifier circuitry, and peaking amplifier circuitry,
wherein the phase offset circuitry comprises lines connecting the driver amplification circuitry and the balun circuitry,
wherein the balun circuitry comprises a first transformer for the carrier amplifier circuitry and a second transformer for the peaking amplifier circuitry,
wherein a first line of the lines is configured to provide a first single-ended signal to the first transformer, and
wherein a second line of the lines is configured to provide a second single-ended signal to the second transformer.
